# EUROPEAN PATENT APPLICATION

(11) **EP 4 738 422 A1**
(43) Date of publication of application: **06.05.2026**
(21) Application number: 24871394.3
(22) Date of filing: 13.06.2024
(51) Int. Cl.: H01J 1/16, H01J 1/146, H01J 35/06, H01J 37/065

(54) **ELECTRON SOURCE, AND ELECTRON GUN AND DEVICE USING SAME**

(30) Priority: 27.09.2023 JP 2023164212
(71) Applicant: Hamamatsu Photonics K.K., Hamamatsu-shi, Shizuoka 435-8558 (JP)
(72) Inventor: HASEGAWA, Yoshito, Hamamatsu-shi, Shizuoka 435-8558 (JP); FUJITA, Toru, Hamamatsu-shi, Shizuoka 435-8558 (JP); TAKEDA, Mamoru, Hamamatsu-shi, Shizuoka 435-8558 (JP)
(74) Representative: Grünecker Patent- und Rechtsanwälte PartG mbB
(86) International application number: PCT/JP2024/021521
(87) International publication number: WO 2025/069589

(57) **Abstract**

An electron source includes an electron emitting portion containing an alloy of iridium and a rare earth element, a support portion made of a metal, and a joining portion joining the electron emitting portion and the support portion. The joining portion has a coating layer containing iridium and the metal in the support portion, and the coating layer comprises iridium and the metal in the support portion.

## Description

### Technical Field

The present disclosure relates to an electron source, an electron gun and a device using the same.

### Background Art

In devices such as X-ray generators, electron beam generators, electron beam-based metal 3D printers, and electron microscopes (SEM and TEM), an electron gun including an electron source is used. The electron source includes an electron emitting portion and a filament that heats the electron emitting portion.

As such an electron source, for example, an electron source described in Non-Patent Literature 1 below is known. The document describes that an IrCe emitter is welded to a tungsten heater filament.

### Citation List

### Non Patent Literature

[Non-Patent Literature 1] Roberto Rao and Oleg Kultashev, "Ir-Ce cathodes as high-density emitters in electron beam ion sources", 1997, Measurement Science Technology, Volume 8, Number 2, 184

### Summary of Invention

### Technical Problem

In an electron source, it is desirable to stabilize the emission amount of an electron beam emitted from an electron emitting portion. For this purpose, it is desired that the temperature of the electron emitting portion is stable during heating.

However, the electron source described in Non-Patent Literature 1 has room for improvement in terms of improving the temperature stability of the electron emitting portion during heating.

An object of the present disclosure is to provide an electron source capable of improving the temperature stability of an electron emitting portion during heating, an electron gun and an electronic device using the same.

### Solution to Problem

An electron source of the present disclosure provides an electron source including: an electron emitting portion containing an alloy of iridium and a rare earth element; a support portion made of a metal; and a joining portion that joins the electron emitting portion and the support portion, wherein the joining portion has a coating layer that covers a surface of the support portion, and the coating layer contains iridium and the metal in the support portion.

According to the electron source, the joining portion has the coating layer covering the surface of the support portion, and the coating layer contains iridium and the metal in the support portion. That is, the coating layer includes both the iridium in the electron emitting portion and the metal in the support portion. For this reason, the coefficient of thermal expansion of the coating layer becomes close to both the coefficient of thermal expansion of the electron emitting portion and the coefficient of thermal expansion of the support portion. Therefore, even when the electron emitting portion is heated by heat generated by energization of the support portion and stress is generated in the joining portion due to a difference in coefficient of thermal expansion between the support portion and the electron emitting portion, the stress is relieved by the coating layer, and the occurrence of cracks in the electron emitting portion is suppressed. As a result, the electron source of the present disclosure can improve the temperature stability of the electron emitting portion during heating.

In the electron source, it is preferable that the joining portion further includes a surrounding portion that couples the coating layer and the electron emitting portion and contains iridium, and in the surrounding portion, a concentration of the rare earth element is less than or equal to a concentration of the rare earth element in the electron emitting portion.

In this case, since the surrounding portion contains the same iridium as the electron emitting portion and has a concentration of the rare earth element that is less than or equal to the concentration of the rare earth element in the electron emitting portion, a reaction due to heat is less likely to occur between the electron emitting portion and the surrounding portion, and erosion and contamination of the electron emitting portion due to the reaction are suppressed. As a result, the electron source can further improve the temperature stability of the electron emitting portion during heating.

In the electron source, it is preferable that the surrounding portion contains an alloy of the iridium and a rare earth element, and a concentration of the rare earth element in the surrounding portion is lower than a concentration of the rare earth element in the electron emitting portion. In this case, the melting point of the surrounding portion becomes lower than the melting point of the electron emitting portion, and the surrounding portion becomes softer than the electron emitting portion. Therefore, even if the support portion expands during heating, the stress due to the expansion is relieved not only by the coating layer but also by the surrounding portion, so that the occurrence of cracks in the electron emitting portion is further suppressed.

The electron source is particularly useful when the coefficient of thermal expansion of the electron emitting portion is greater than the coefficient of thermal expansion of the support portion.

This is because if the coefficient of thermal expansion of the electron emitting portion is greater than the coefficient of thermal expansion of the support portion, stress is more likely to be generated in the joining portion due to the difference in coefficient of thermal expansion between the support portion and the electron emitting portion when the electron emitting portion is heated.

In the electron source, it is preferable that the coating layer is a sintered body containing voids.

When the coating layer is a sintered body containing voids, even if stress is generated in the coating layer during heating, the stress is easily absorbed and relieved by the voids in the sintered body, and the occurrence of cracks in the electron emitting portion is further suppressed. As a result, the electron source can further improve the temperature stability of the electron emitting portion during heating.

It is preferable that the surrounding portion is a sintered body containing voids.

When the surrounding portion is a sintered body containing voids, even if stress is generated in the surrounding portion during heating, the stress is easily absorbed and relieved by the voids in the sintered body, and the occurrence of cracks in the electron emitting portion is further suppressed. As a result, the electron source can further improve the temperature stability of the electron emitting portion during heating.

In the electron source, it is preferable that a part of the support portion penetrates the joining portion.

In this case, compared to a case where a part of the support portion does not penetrate the joining portion, the contact area between the support portion and the joining portion becomes larger, and heat generated by energization of the support portion is transmitted to the electron emitting portion via the joining portion, so that the electron emitting portion can be efficiently heated. In addition, since a part of the support portion penetrates the joining portion, the support portion is firmly fixed by the joining portion, which makes it difficult for the electron emitting portion to be detached from the support portion.

In the electron source, it is preferable that the metal in the support portion is composed of at least one selected from the group consisting of tungsten, iridium, molybdenum, tantalum, and rhenium. In this case, deformation of the support portion can be suppressed even if the support portion is energized and heated to a temperature at which electrons are emitted from the electron emitting portion.

In the electron source, the rare earth element of the electron emitting portion may be composed of at least one selected from the group consisting of cerium, lanthanum, and praseodymium.

In the electron source, it is preferable that the rare earth element is cerium, and the alloy of the electron emitting portion is composed of at least one selected from the group consisting of Ir₂Ce, Ir₃Ce, Ir₅Ce, and Ir₇Ce₂.

In this case, the life of the electron emitting portion can be extended, so that the life of the electron source can be extended.

Another aspect of the present disclosure provides an electron gun including the above-described electron source.

With this electron gun, electrons are emitted from the electron emitting portion when the electron source is heated, and are emitted as an electron beam. At this time, since the electron source can improve the temperature stability of the electron emitting portion during heating, the electron gun can improve the stability of the emission amount of the electron beam.

Still another aspect of the present disclosure provides a device including the above-described electron gun.

With this device, since the stability of the emission amount of the electron beam can be improved, the performance of the device can be improved.

### Advantageous Effects of Invention

According to the present disclosure, an electron source capable of improving the temperature stability of an electron emitting portion during heating, an electron gun and a device using the same are provided.

### Brief Description of Drawings

FIG. 1 is a schematic configuration diagram illustrating an embodiment of a device of the present disclosure.
FIG. 2 is a partial cross-sectional front view illustrating an embodiment of an electron gun of FIG. 1.
FIG. 3 is a cross-sectional view taken along line III-III in FIG. 2.
FIG. 4 is a diagram illustrating a modification of the electron source of FIG. 3.
FIG. 5 is a cross-sectional view illustrating another embodiment of the electron gun of FIG. 1.
FIG. 6 is a graph illustrating a change over time in the temperature of the electron emitting portion according to Example 1.
FIG. 7 is a graph illustrating a change over time in the temperature of the electron emitting portion according to Example 2.
FIG. 8 is a graph illustrating a change over time in the temperature of the electron emitting portion according to Comparative Example 1.

### Description of Embodiments

Hereinafter, preferred embodiments of an electron source, an electron gun, and a device of the present disclosure will be described in detail with reference to the accompanying drawings. In the following description, the same elements or elements having equivalent functions are denoted by the same reference signs, and redundant description will be omitted.

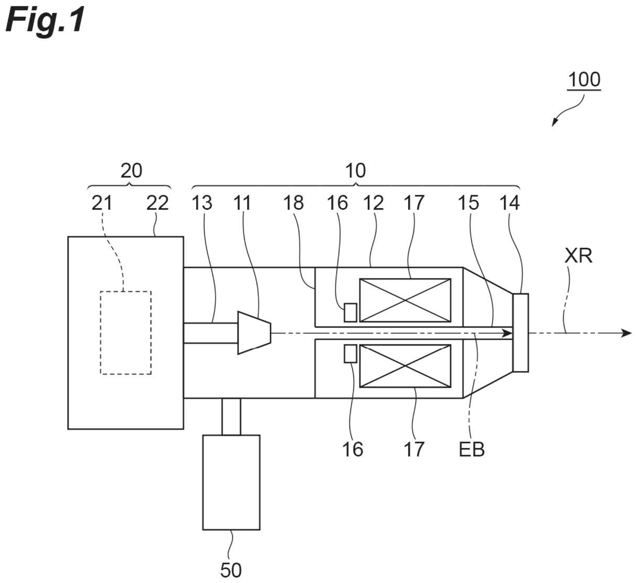

A device 100 illustrated in FIG. 1 is an X-ray generator that generates X-rays XR, and includes an X-ray emitting portion 10 that emits the X-rays XR, a power supply unit 20 connected to the X-ray emitting portion 10, and a vacuum pump 50 connected to the X-ray emitting portion 10.

The power supply unit 20 includes a power source 21 and a metal case 22 that houses the power source 21. The power source 21 is molded with an electrically insulating resin (for example, epoxy resin) inside the case 22.

The X-ray emitting portion 10 includes an electron gun 11 that emits an electron beam EB, and a tube-shaped portion 12 made of metal (for example, stainless steel) that is connected to the case 22 and houses the electron gun 11.

The electron gun 11 is fixed to a neck portion 13 made of resin or the like inside the tube-shaped portion 12, and is electrically connected to the power source 21. The electron gun 11 is capable of emitting the electron beam EB with electric power supplied from the power source 21.

A target 14 that converts the electron beam EB emitted from the electron gun 11 into X-rays XR and emits them is fixed to a tip of the tube-shaped portion 12.

A partition plate 18 is installed inside the tube-shaped portion 12, and an electron path 15 extends along a direction connecting the partition plate 18 and the target 14. Around the electron path 15, a pair of tube-shaped coil portions 16 and 17 that function as an electromagnetic lens are arranged along the electron path 15.

The vacuum pump 50 is connected to the tube-shaped portion 12 and is capable of evacuating an internal space of the tube-shaped portion 12 to create a vacuum state.

In the device 100, when electric power is supplied from the power source 21 to the electron gun 11 in a state where the inside of the tube-shaped portion 12 is evacuated by the vacuum pump 50, the electron beam EB is emitted from the electron gun 11. Then, the electron beam EB passes through the electron path 15 while being focused and deflected by the coil portions 16 and 17, is irradiated onto the target 14, and the X-rays XR are emitted from the target 14.

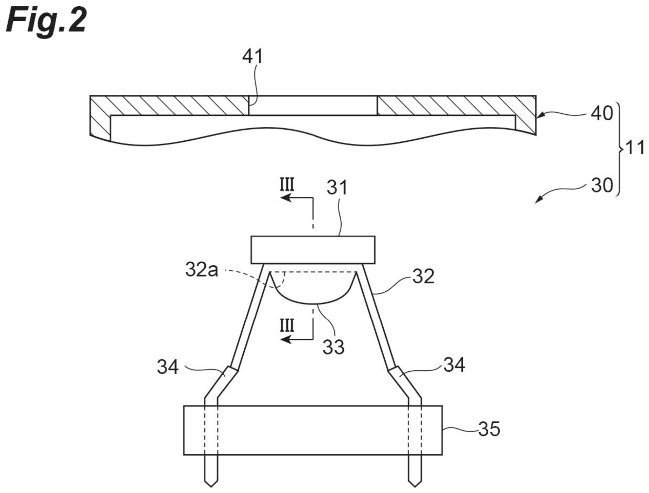

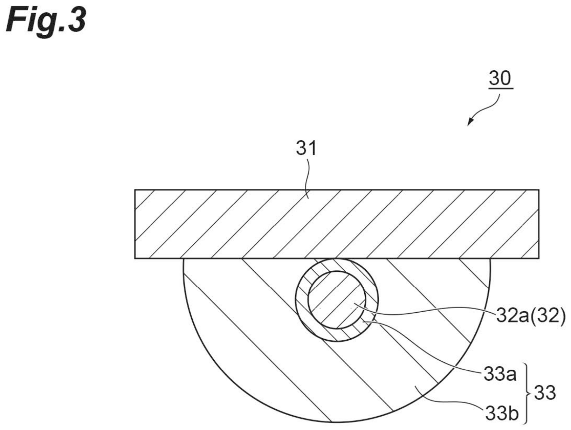

The electron gun 11 will be described in detail with reference to FIGS. 2 and 3. FIG. 2 is a partial cross-sectional front view illustrating an embodiment of the electron gun of FIG. 1, and FIG. 3 is a cross-sectional view taken along line III-III of FIG. 2.

As illustrated in FIG. 2, the electron gun 11 includes an electron source 30 and an electrode 40. A voltage can be applied to the electron source 30 and the electrode 40 by the power source 21.

The electrode 40 has a beam passage opening 41 that allows the electron beam EB emitted from the electron source 30 to pass through.

The electron source 30 includes a plate-shaped electron emitting portion 31 arranged to face the electrode 40, a wire-like filament (support portion) 32 having a circular cross-section, and a joining portion 33 that joins the electron emitting portion 31 and the filament 32. The electron emitting portion 31 contains an alloy of iridium and a rare earth element, and the filament 32 is made of metal. In this embodiment, the filament 32 is fixed to a back surface of the electron emitting portion 31, which is opposite to an electron emitting surface from which electrons are emitted.

Power supply pins 34 are connected to both ends of the filament 32, respectively, and the power supply pins 34 may penetrate a plate-shaped insulating support member 35 and be fixed to the insulating support member 35. The insulating support member 35 is composed of, for example, ceramic or the like. Electric power can be supplied to the power supply pins 34.

As illustrated in FIG. 3, the joining portion 33 includes a coating layer 33a containing iridium and the metal in the filament 32. The joining portion 33 may further include a surrounding portion 33b that surrounds a part of the coating layer 33a. Here, the surrounding portion 33b can also be referred to as a coupling portion that couples the coating layer 33a and the electron emitting portion 31.

According to the electron source 30, the joining portion 33 has the coating layer 33a covering the surface of the filament 32, and the coating layer 33a contains iridium and the metal in the filament 32. That is, the coating layer 33a contains both the iridium in the electron emitting portion 31 and the metal in the filament 32. For this reason, the coefficient of thermal expansion of the coating layer 33a becomes close to both the coefficient of thermal expansion of the electron emitting portion 31 and the coefficient of thermal expansion of the filament 32. Therefore, even when the electron emitting portion 31 is heated by heat generated by energization of the filament 32 and stress is generated in the joining portion 33 due to a difference in coefficient of thermal expansion between the filament 32 and the electron emitting portion 31, the stress is relieved by the coating layer 33a, and the occurrence of cracks in the electron emitting portion 31 is suppressed. As a result, the electron emitting portion 31 and the filament 32 can maintain a stable joined state, and the electron source 30 can improve the temperature stability of the electron emitting portion 31 during heating. For this reason, the electron gun 11 can improve the stability of the emission amount of the electron beam EB. Therefore, the device 100 can improve its performance. Specifically, the stability of the emission amount of the X-rays XR can be improved.

Hereinafter, the electron source 30 will be described in more detail.

### <Electron Emitting Portion>

The electron emitting portion 31 is a portion that emits electrons when heated by the filament 32.

The electron emitting portion 31 contains an alloy of iridium and a rare earth element.

Examples of the rare earth elements include cerium, lanthanum, and praseodymium. These may be used alone or in a combination of two or more thereof.

Here, it is preferable that the rare earth element is cerium, and the alloy of the electron emitting portion 31 is composed of at least one selected from the group consisting of Ir₂Ce, Ir₃Ce, Ir₅Ce, and Ir₇Ce₂.

In this case, the life of the electron emitting portion 31 can be extended, so that the life of the electron source 30 can be extended.

In particular, it is preferable that the alloy of the electron emitting portion 31 is composed of at least one selected from the group consisting of Ir₂Ce, Ir₃Ce, and Ir₇Ce₂. In this case, the electron emitting portion 31 is less likely to change over time, and a longer life can be achieved.

The coefficient of thermal expansion of the electron emitting portion 31 may be greater than or less than or equal to the coefficient of thermal expansion of the filament 32, but the electron source 30 is particularly useful when it is greater than the coefficient of thermal expansion of the filament 32. This is because if the coefficient of thermal expansion of the electron emitting portion 31 is greater than the coefficient of thermal expansion of the filament 32, stress is more likely to be generated in the joining portion 33 due to the difference in the coefficients of thermal expansion between the filament 32 and the electron emitting portion 31 when the electron emitting portion 31 is heated.

The electron emitting portion 31 may be a sintered body containing voids or a solid body not containing voids, but is preferably a solid body not containing voids.

When the electron emitting portion 31 is a solid body not containing voids, the electron emitting portion 31 is less likely to change over time, and a longer life can be achieved.

### <Filament>

The filament 32 is made of a metal. The metal is not particularly limited as long as it is a metal that does not deform or melt even when energized and heated to a temperature at which electrons are emitted from the electron emitting portion 31, and may be iridium or a metal other than iridium.

As such a metal, a high-melting-point metal is preferable.

A high-melting-point metal refers to a metal having a melting point of about 1800°C or higher.

As the high-melting-point metal, for example, tungsten, iridium, molybdenum, tantalum, and rhenium are preferable. These may be used alone or in a combination of two or more thereof. In this case, deformation of the filament 32 can be suppressed even if the filament 32 is energized and heated to a temperature at which electrons are emitted from the electron emitting portion 31.

As the high-melting-point metal, tungsten is preferable because it has a low coefficient of thermal expansion and is particularly unlikely to deform upon energization.

The filament 32 has a fixing portion 32a fixed to the joining portion 33. The fixing portion 32a may be embedded in the joining portion 33 and penetrate the joining portion 33, or may be exposed on the surface of the joining portion 33 and not penetrate the joining portion 33, but it is preferable that the fixing portion 32a is embedded in the joining portion 33 and penetrates the joining portion 33.

In this case, compared to a case where the fixing portion 32a of the filament 32 does not penetrate the joining portion 33, the contact area between the filament 32 and the joining portion 33 is larger, and heat generated in the fixing portion 32a by energization of the filament 32 is transmitted to the electron emitting portion via the joining portion 33, so that the electron emitting portion can be efficiently heated. In addition, since the filament 32 has the fixing portion 32a and the fixing portion 32a penetrates the joining portion 33, the filament 32 is firmly fixed by the joining portion 33, which makes it difficult for the electron emitting portion 31 to be detached from the filament 32.

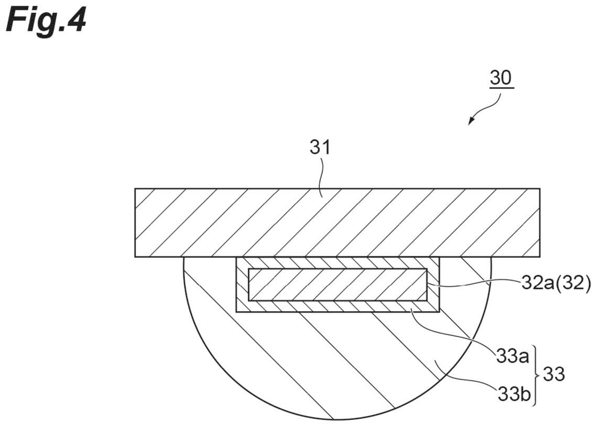

The fixing portion 32a of the filament 32 is a solid cylindrical body having a circular cross-section in FIG. 3, and the filament 32 as a whole is composed of, for example, a wire-like member. However, as illustrated in FIG. 4, it may be a ribbon body (a flat plate-like member) having a rectangular cross-section. In this case, if a long side of the rectangular cross-section in the fixing portion 32a of the filament 32 is directed toward the electron emitting portion 31, the contact area between the electron emitting portion 31 and the fixing portion 32a of the filament 32 via the coating layer 33a of the joining portion 33 can be increased, so that the electron emitting portion 31 can be stably fixed on the filament 32. The coating layer 33a may cover the entire circumference of the fixing portion 32a of the filament 32 as illustrated in FIG. 4, or may cover a part of the fixing portion 32a.

Further, the fixing portion 32a of the filament 32 may be an annular body. In this case, the contact area between the electron emitting portion 31 and the fixing portion 32a of the filament 32 via the coating layer 33a of the joining portion 33 can be increased, so that the electron emitting portion 31 can be stably fixed on the filament 32. In addition, if the fixing portion 32a is an annular body, a temperature difference between a portion inside the annular body and a portion outside the annular body on the back surface of the electron emitting portion 31 can be reduced, and temperature unevenness can be reduced in the electron emitting portion 31 as a whole. When the fixing portion 32a of the filament 32 is an annular body, the annular body is arranged along the surface of the electron emitting portion 31.

Further, the fixing portion 32a of the filament 32 may be a spiral body. In this case, the contact area between the electron emitting portion 31 and the fixing portion 32a of the filament 32 via the coating layer 33a of the joining portion 33 can be increased, so that the electron emitting portion 31 can be stably fixed on the filament 32. In addition, if the fixing portion 32a is a spiral body, the fixing portion 32a can be brought into contact with most of the back surface of the electron emitting portion 31, so that temperature unevenness can be sufficiently reduced in the electron emitting portion 31 as a whole. When the fixing portion 32a of the filament 32 is a spiral body, the spiral body is arranged along the surface of the electron emitting portion 31.

### <Joining Portion>

### (Coating Layer)

The coating layer 33a contains iridium and the metal in the filament 32. When the metal contained in the filament 32 is tungsten, the coating layer 33a becomes an alloy layer containing an alloy of iridium and tungsten (Ir-W).

The coating layer 33a may be a sintered body containing voids or a solid body not containing voids, but is preferably a sintered body containing voids.

When the coating layer 33a is a sintered body containing voids, even if stress is generated in the coating layer 33a during heating, the stress is easily absorbed and relieved by the voids in the sintered body, and the occurrence of cracks in the electron emitting portion 31 is further suppressed. As a result, the electron source 30 can further improve the temperature stability of the electron emitting portion 31 during heating. When the coating layer 33a is a sintered body containing voids, the coating layer 33a can be formed by sintering and fixing iridium powder on the filament 32.

The thickness of the coating layer 33a is not particularly limited, but is preferably 1 µm or more, and more preferably 10 µm or more. The thickness of the coating layer 33a may be 100 µm or less, and may be 50 µm or less.

Although the coating layer 33a is in contact with the back surface of the electron emitting portion 31 in FIG. 3, it may be separated from the back surface of the electron emitting portion 31.

### (Surrounding Portion)

The surrounding portion 33b contains iridium, and it is preferable that in the surrounding portion 33b, the concentration of the rare earth element is less than or equal to the concentration of the rare earth element in the electron emitting portion 31. For example, when the electron emitting portion 31 contains Ir₂Ce, the surrounding portion 33b may contain at least one selected from the group consisting of Ir₂Ce, Ir₃Ce, Ir₇Ce₂, Ir₅Ce, and Ir. When the electron emitting portion 31 contains Ir₃Ce, the surrounding portion 33b may contain at least one selected from the group consisting of Ir₃Ce, Ir₇Ce₂, Ir₅Ce, and Ir. When the electron emitting portion 31 contains Ir₇Ce₂, the surrounding portion 33b may contain at least one selected from the group consisting of Ir₇Ce₂, Ir₅Ce, and Ir. When the electron emitting portion 31 contains, for example, Ir₅Ce, the surrounding portion 33b may contain Ir₅Ce and Ir. The surrounding portion 33b may also contain the metal in the filament 32.

When the concentration of the rare earth element in the surrounding portion 33b is less than or equal to the concentration of the rare earth element in the electron emitting portion 31, since the surrounding portion 33b contains the same iridium as the electron emitting portion 31 and has a concentration of the rare earth element that is less than or equal to the concentration of the rare earth element in the electron emitting portion 31, a reaction due to heat is less likely to occur between the electron emitting portion 31 and the joining portion 33, and erosion and contamination of the electron emitting portion 31 due to the reaction are suppressed. As a result, the electron source 30 can further improve the temperature stability of the electron emitting portion 31 during heating. The concentration of the rare earth element in the surrounding portion 33b may be zero. That is, the surrounding portion 33b need not contain a rare earth element.

Furthermore, it is preferable that the surrounding portion 33b contains an alloy of iridium and a rare earth element, and the concentration of the rare earth element in the surrounding portion 33b is lower than the concentration of the rare earth element in the electron emitting portion 31. For example, when the electron emitting portion 31 contains Ir₂Ce, the surrounding portion 33b may contain at least one selected from the group consisting of Ir₃Ce, Ir₇Ce₂, and Ir₅Ce. When the electron emitting portion 31 contains Ir₃Ce, the surrounding portion 33b may contain at least one selected from the group consisting of Ir₇Ce₂ and Ir₅Ce. When the electron emitting portion 31 contains Ir₇Ce₂, the surrounding portion 33b may contain at least one selected from the group consisting of Ir₅Ce.

When the concentration of the rare earth element in the surrounding portion 33b is lower than the concentration of the rare earth element in the electron emitting portion 31, the melting point of the surrounding portion 33b becomes lower than the melting point of the electron emitting portion 31, and the surrounding portion 33b becomes softer than the electron emitting portion 31. Therefore, even if the filament 32 expands during heating, the stress due to the expansion is relieved not only by the coating layer 33a but also by the surrounding portion 33b, so that the occurrence of cracks in the electron emitting portion 31 is further suppressed.

The surrounding portion 33b may be a sintered body containing voids or a solid body not containing voids, but is preferably a sintered body containing voids.

When the surrounding portion 33b is a sintered body containing voids, even if stress is generated in the surrounding portion 33b during heating, the stress is easily absorbed and relieved by the voids in the sintered body, and the occurrence of cracks in the electron emitting portion 31 is further suppressed. As a result, the electron source 30 can further improve the temperature stability of the electron emitting portion 31 during heating.

When the surrounding portion 33b is a sintered body containing voids, the surrounding portion 33b can be formed by joining the electron emitting portion 31 and a composite body obtained by forming the coating layer 33a on the filament 32, for example, by sintering an alloy powder of iridium and a rare earth element.

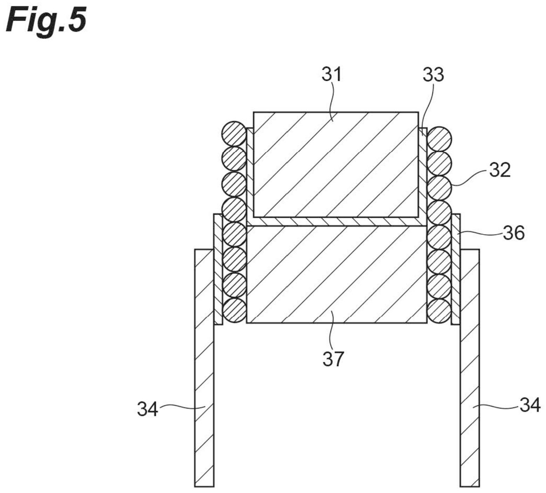

The present disclosure is not limited to the above-described embodiments. For example, in the electron source 30 of the above-described embodiment, the filament 32 is fixed to the back surface of the electron emitting portion 31 opposite to the electron emitting surface from which electrons are emitted, but like the electron source illustrated in FIG. 5, the electron emitting portion 31 may be fixed inside a tube-shaped filament 32 via a joining portion 33. Here, a coating layer 33a (not illustrated in FIG. 5) of the joining portion 33 is provided on an inner surface side of the filament 32. The tube-shaped filament 32 may be in a form in which a wire having a circular cross-section is wound in a coil shape (see FIG. 5), or may be in a form in which a ribbon material having a rectangular cross-section is wound in a coil shape. As illustrated in FIG. 5, a pedestal 37 for supporting the electron emitting portion 31 may be further provided inside the tube-shaped filament 32, but the pedestal 37 may be omitted and the electron emitting portion 31 may be extended downward. The pedestal 37 may be made of, for example, the same material as the filament 32, and in this case, it is preferable that the joining portion 33 is also provided between the pedestal 37 and the electron emitting portion 31. Here, the coating layer 33a of the joining portion 33 is provided on the pedestal 37 side. The power supply pin 34 may be connected to the filament 32 via a tantalum foil 36 or the like.

The electron source illustrated in FIG. 5 can be obtained by fixing the pedestal 37 inside the tube-shaped filament 32, fixing the electron emitting portion 31 inside the filament 32 using a powder or a molded body made of an alloy of iridium and the metal in the filament 32 as a brazing material, and then joining the power supply pin 34 by welding via the tantalum foil 36.

Furthermore, in the above-described embodiment, the electron gun 11 includes the electron source 30 and the electrode 40, but the electron gun of the present disclosure may not include the electrode 40.

Further, in the electron source of the present disclosure, the electron emitting portion 31 may be fixed via the joining portion 33 on the filament 32 including a metal foil. This electron source can be obtained by fixing the electron emitting portion 31 on the metal foil of the filament 32 using a powder or a molded body made of an alloy of iridium and the metal in the filament 32 as a brazing material.

Further, the device of the present disclosure is not limited to the device of the above-described embodiment. For example, although the device 100 of the above-described embodiment is an X-ray generator, the device of the present disclosure is not particularly limited as long as it is a device including an electron source, and may be an electron beam generator, an electron beam-based metal 3D printer, an electron microscope (SEM and TEM), or the like.

The summary of the present disclosure is as follows.
**[1]** An electron source comprising:
   an electron emitting portion containing an alloy of iridium and a rare earth element;
   a support portion made of a metal; and
   a joining portion joining the electron emitting portion and the support portion,
   wherein the joining portion has a coating layer covering a surface of the support portion, and
   wherein the coating layer contains iridium and the metal in the support portion.
[2] The electron source according to [1], wherein the joining portion further comprises a surrounding portion surrounding at least a part of the coating layer and comprising iridium, and
   wherein, in the surrounding portion, a concentration of the rare earth element is less than or equal to a concentration of the rare earth element in the electron emitting portion.
[3] The electron source according to [2], wherein the surrounding portion contains the alloy of the iridium and the rare earth element, and a concentration of the rare earth element in the surrounding portion is lower than a concentration of the rare earth element in the electron emitting portion.
[4] The electron source according to any one of [1] to [3], wherein a coefficient of thermal expansion of the electron emitting portion is greater than a coefficient of thermal expansion of the support portion.
[5] The electron source according to any one of [1] to [4], wherein the coating layer is a sintered body containing voids.
[6] The electron source according to [2] or [3], wherein the surrounding portion is a sintered body containing voids.
[7] The electron source according to any one of [1] to [6], wherein a part of the support portion penetrates the joining portion.
[8] The electron source according to any one of [1] to [7], wherein the metal in the support portion is composed of at least one selected from the group consisting of tungsten, iridium, molybdenum, tantalum, and rhenium.
[9] The electron source according to any one of [1] to [8], wherein the rare earth element of the electron emitting portion is composed of at least one selected from the group consisting of cerium, lanthanum, and praseodymium.
[10] The electron source according to [9], wherein the rare earth element is cerium, and
   wherein the alloy of the electron emitting portion is composed of at least one selected from the group consisting of Ir₂Ce, Ir₃Ce, Ir₅Ce, and Ir₇Ce₂.
[11] An electron gun comprising the electron source according to any one of [1] to [10].
[12] A device comprising the electron gun according to [11]. Examples

Hereinafter, the present disclosure will be described more specifically based on examples, but the present disclosure is not limited to the following examples.

### (Example 1)

An electron source 30 illustrated in FIG. 2, excluding the power supply pins 34 and the insulating support member 35, was fabricated.

Specifically, a disk-shaped electron emitting portion made of Ir₂Ce with a thickness of 0.3 mm and a diameter of 2.0 mm was prepared.

On the other hand, a tungsten filament with a length of 10 mm and a diameter of 0.15 mm was prepared and bent into a U-shape.

Then, Ir powder was prepared, and the Ir powder was sintered at 1600°C for 15 hours with a central portion of the U-shaped tungsten filament embedded in the Ir powder, to form a coating layer made of a first sintered body around the central portion of the tungsten filament. In this way, a tungsten filament with a coating layer was obtained.

Subsequently, the tungsten filament with the coating layer was placed such that the coating layer was positioned on a back surface of the electron emitting portion opposite to an electron emitting surface, and the Ir₅Ce powder was sintered at 1600°C for 15 hours with the coating layer embedded in the Ir₅Ce powder, to form a surrounding portion made of a second sintered body.

An electron source was obtained as described above. When the composition of the formed coating layer and surrounding portion was analyzed by energy dispersive X-ray spectroscopy, it was confirmed that the coating layer contained Ir and W, and the surrounding portion contained Ir₃Ce, Ir₇Ce₂, Ir₅Ce, and Ir-W. The thickness of the coating layer was 40 µm.

### (Example 2)

An electron source 30 illustrated in FIG. 2, excluding the power supply pins 34 and the insulating support member 35, was fabricated. Specifically, a disk-shaped electron emitting portion made of Ir₂Ce with a thickness of 0.5 mm and a diameter of 0.8 mm was prepared in the same manner as in Example 1.

On the other hand, a tungsten filament with a length of 10 mm and a diameter of 0.15 mm was prepared and bent into a U-shape.

Then, the tungsten filament was placed such that its central portion was positioned on a back surface of the electron emitting portion opposite to an electron emitting surface, and the Ir₅Ce powder was sintered at 1600°C for 15 hours with the central portion embedded in the Ir₅Ce powder, to form a sintered body.

An electron source was obtained as described above. When the composition of the formed sintered body was analyzed by energy dispersive X-ray spectroscopy, it was confirmed that the sintered body was composed of a coating layer covering the central portion of the tungsten filament and a surrounding portion joining the coating layer and the electron emitting portion, that the coating layer contained Ir-W, and that the surrounding portion contained Ir₃Ce, Ir₇Ce₂, Ir₅Ce, and Ir-W.

### (Comparative Example 1)

First, a solid cylindrical electron emitting portion made of Ir₇Ce₂ with a thickness of 1.0 mm and a diameter of 1.2 mm was prepared in the same manner as in Example 1.

On the other hand, a tantalum foil with a thickness of 0.03 mm × a width of 0.6 mm × a length of 4.5 mm was prepared, and two rhenium filaments with a length of 4.5 mm and a diameter of 0.2 mm were prepared.

Then, the two rhenium filaments were joined to the electron emitting portion by welding via the tantalum foil and tungsten powder. An electron source was obtained as described above.

### <Evaluation of Temperature Stability of Electron Emitting Portion in Electron Source>

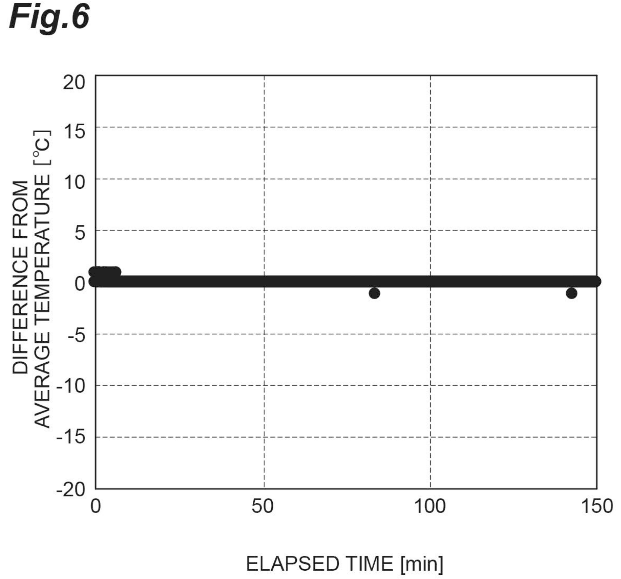

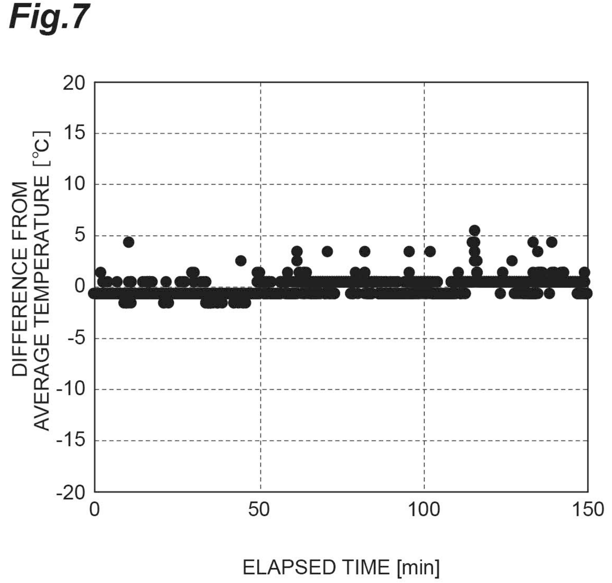

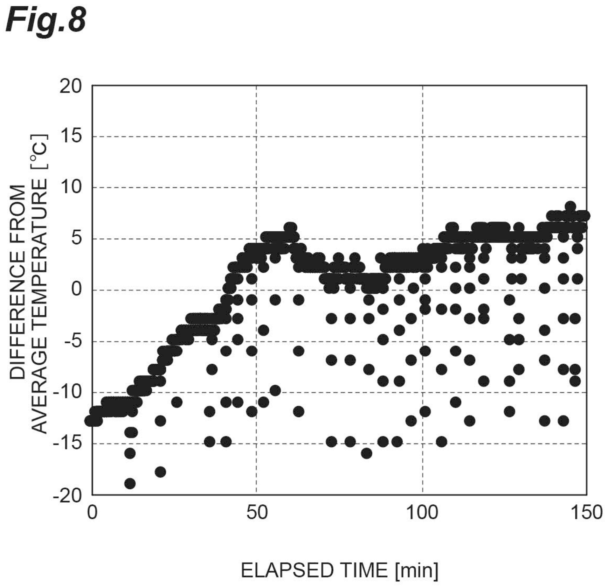

For the electron sources of the Examples and Comparative Example obtained as described above, the electron emitting portion was energized and heated while applying a current of 4 to 5 A, and the temperature of the electron emitting portion was measured every 5 or 10 seconds to examine the change over time in the temperature of the electron emitting portion. The results are illustrated in FIGS. 6 to 8. In FIGS. 6 to 8, the vertical axis indicates the difference between the measured temperature and the average temperature, and the horizontal axis indicates the elapsed time (minutes) from the measurement start time. At this time, the temperature of the electron emitting portion was measured using a two-color pyrometer, which is a non-contact thermometer. Based on the measurement results of the temperature of the electron emitting portion, the average temperature and standard deviation of the measured temperatures were calculated. The results are shown in Table 1. Since the standard deviation indicates the variation of the measured temperature from the average temperature, the value of this standard deviation was used as an evaluation index for temperature stability.

**[Table 1]**

| | Average Temperature (°C) | Standard Deviation |
|---|---|---|
| Example 1 | 1494.01 | 0.11 |
| Example 2 | 1405.52 | 0.70 |
| Comparative Example 1 | 1415.11 | 5.81 |

From the results shown in Table 1, it was found that the electron sources of Examples 1 and 2 had a smaller standard deviation of the temperature of the electron emitting portion than the electron source of Comparative Example 1.

Therefore, it was confirmed that the electron source of the present disclosure can improve the temperature stability of the electron emitting portion during heating.

### Industrial Applicability

The electron source of the present disclosure can be used for electron guns, X-ray generators, electron beam generators, electron beam-based metal 3D printers, electron microscopes (SEM and TEM), and the like.

### Reference Signs List

100: device; 11: electron gun; 16, 17: coil portion; 30: electron source; 31: electron emitting portion; 32: filament (support portion); 33: joining portion; 33a: coating layer; 33b: surrounding portion; 40: electrode; EB: electron beam; XR: X-ray.

## Claims

1. An electron source comprising:
an electron emitting portion containing an alloy of iridium and a rare earth element;
a support portion made of a metal; and
a joining portion joining the electron emitting portion and the support portion,
wherein the joining portion has a coating layer covering a surface of the support portion, and
wherein the coating layer contains iridium and the metal in the support portion.

2. The electron source according to claim 1, wherein the joining portion further comprises a surrounding portion surrounding at least a part of the coating layer and containing iridium, and
wherein, in the surrounding portion, a concentration of a rare earth element is less than or equal to a concentration of the rare earth element in the electron emitting portion.

3. The electron source according to claim 2, wherein the surrounding portion contains the alloy of the iridium and a rare earth element, and a concentration of a rare earth element in the surrounding portion is lower than a concentration of the rare earth element in the electron emitting portion.

4. The electron source according to any one of claims 1 to 3, wherein a coefficient of thermal expansion of the electron emitting portion is greater than a coefficient of thermal expansion of the support portion.

5. The electron source according to any one of claims 1 to 3, wherein the coating layer is a sintered body containing voids.

6. The electron source according to claim 2 or 3, wherein the surrounding portion is a sintered body containing voids.

7. The electron source according to any one of claims 1 to 3, wherein a part of the support portion penetrates the joining portion.

8. The electron source according to any one of claims 1 to 3, wherein the metal in the support portion is composed of at least one selected from the group consisting of tungsten, iridium, molybdenum, tantalum, and rhenium.

9. The electron source according to any one of claims 1 to 3, wherein the rare earth element of the electron emitting portion is composed of at least one selected from the group consisting of cerium, lanthanum, and praseodymium.

10. The electron source according to claim 9, wherein the rare earth element is cerium, and
wherein the alloy of the electron emitting portion is composed of at least one selected from the group consisting of Ir₂Ce, Ir₃Ce, Ir₅Ce, and Ir₇Ce₂.

11. An electron gun comprising the electron source according to claim 1.

12. A device comprising the electron gun according to claim 11.
